# FASCICULE DE BREVET EUROPEEN

(11) **EP 1 969 605 B1**
(45) Date de publication et mention de la délivrance du brevet: **26.08.2009**
(21) Numéro de dépôt: 07703614.3
(22) Date de dépôt: 03.01.2007
(51) Int. Cl.: G11C 16/34

(54) **PROCEDE DE GESTION DE DONNEES DESTINEES A ETRE ECRITES ET LUES DANS UNE MEMOIRE**
VERFAHREN ZUR VERWALTUNG VON DATEN, DIE AUF EINEN SPEICHER GESCHRIEBEN UND VON DIESEM AUSGELESEN WERDEN SOLLEN
METHOD OF MANAGING DATA INTENDED TO BE WRITTEN TO AND READ FROM A MEMORY

(30) Priorité: 03.01.2006 FR 0600030
(43) Date de publication de la demande: 17.09.2008
(73) Titulaire: Thales, 92526 Neuilly Sur Seine (FR)
(72) Inventeur: COLLIAU, Florent, 41190 Chambon sur Cisse (FR)
(74) Mandataire: Collet, Alain
(86) Numéro de dépôt international: PCT/EP2007/050048
(87) Numéro de publication internationale: WO 2007/077242

(56) Documents cités:
- EP-A- 0 887 732
- US-A- 5 404 485
- US-A- 5 832 493
- US-A- 5 943 692

## Description

L'invention concerne un procédé de gestion de données destinées à être écrites et lues dans une mémoire. Les systèmes électroniques nécessitant un logiciel ont généralement besoin pour leur fonctionnement de trois types d'informations rémanentes : d'une part des programmes et des données accessibles en lecture uniquement et d'autre part de données accessibles en lecture et en écriture.

Une solution consiste à utiliser des mémoires de types différents suivant que les informations doivent être uniquement lues ou bien que les informations doivent être écrites, lues et modifiées.

Dans le premier cas, lecture uniquement, on utilise des mémoires en lecture seule programmables rapides bien connues dans la littérature anglo saxonne sons le nom de « FlashPROM ». Les mémoires de type FlashPROM sont particulièrement bien adaptées. Il s'agit de mémoires mortes très rapides et permettant le stockage d'un gros volume d'information sur une faible surface. Ces mémoires consomment peu d'énergie électrique. Ce type de mémoire est organisé en blocs appelés pages et en cours de fonctionnement, il n'est possible d'effacer les informations stockées qu'en effaçant au moins une page entière. Il n'est pas possible d'effacer une partie seulement d'une page. Les mémoires de type FlashPROM ne sont pas adaptées au stockage de données destinées à être modifiées en cours de fonctionnement lorsque ces données sont de taille inférieure à la taille d'une page. On se procure facilement des mémoires de type FlashPROM dont la taille des pages est comprise entre 1 et 10 kilo octets. On comprend donc que ce type de mémoire n'est pas adapté pour des données de quelques octets et destinées à être modifiées.

L'invention ne s'intéresse pas aux données dynamiques habituellement stockées dans une mémoire à accès aléatoire bien connue dans la littérature anglo saxonne sons le nom de RAM. L'invention s'intéresse aux données ayant une faible occurrence de lecture, écriture et effacement. A titre d'exemple, on peut citer les historiques de pannes survenant dans un système électronique.

Pour de telles données, on peut utiliser des mémoires en lecture seule effaçable électriquement bien connues dans la littérature anglo saxonne sons le nom de « EEPROM ». Ce sont des mémoires mortes permettant le stockage, l'effacement et la réécriture de données individuelles de tailles variables. Par rapport aux mémoires de type FlashPROM, les mémoires de type EEPROM sont moins rapides, de moins grande capacité et consomment plus d'énergie électrique.

Le document US-A-5 943 692 divulge (fig.11) un procédé de gestion de données destinées à être écrites et lues dans une mémoire FLASHPROM organisée en pages (ERASE UNITs) et stockant plusieurs données (BLOCKs) par page, le procédé comprenant
pour chaque page, à réserver une zone (UNIT HEADER) destinée à recevoir le numéro de la page ("offset"; col.10, 1.66 - col.11, I.4); et
pour chaque donnée, à réserver une zone (BLOCK HEADER) pour le statut et la taille de la donnée

Le document US-A-5 832 493 divulgue (fig.1) un procédé de gestion de données où, dans une mémoire de type FLASHPROM organisée en pages (17,18,19,..) et stockant plusieurs données (26,27,28,.) par page, pour chaque page (19), une zone (22,24) est réservée pour recevoir le statut (TABLE 1: eg "ready for erasure"; et col.4, I.10-12) de la page.

L'invention vise à permettre le stockage de données de taille variable que l'on souhaite lire, écrire et effacer ou modifier dans une mémoire de type FlashPROM.

A cet effet, l'invention a pour objet un procédé de gestion de données destinées à être écrites et lues dans une mémoire de type FLASHPROM organisée en pages stockant plusieurs données par page, le procédé consistant:
- pour chaque page, à réserver une zone destinée à recevoir le statut et le numéro de la page,
- pour chaque donnée, à réserver une zone pour le statut et la taille de la donnée, et
à réserver au moins une page permettant la défragmentation de la mémoire.

Le principe de l'invention repose essentiellement sur une gestion d'en-têtes particuliers dans la mémoire, en-têtes pour chaque page et pour chaque donnée à l'intérieur des pages.

La mise en oeuvre de l'invention permet de supprimer la mémoire de type EEPROM en stockant les données qu'elle contient sur une autre mémoire par exemple déjà partiellement utilisée pour stocker le programme permettant le fonctionnement d'un système électronique. En conséquence, l'invention permet de réduire le nombre de composants présent dans le système électronique et de réduire sa consommation électrique.

L'invention sera mieux comprise et d'autres avantages apparaîtront à la lecture de la description détaillée d'un mode de réalisation donné à titre d'exemple, description illustrée par le dessin joint dans lequel :
la figure 1 représente un en-tête d'une page d'une mémoire de type FlashPROM ;
la figure 2 représente la structure d'une donnée destinée à être stockée sur la page représentée sur la figure 1 ;
la figure 3 représente un organigramme de préparation d'une page ;
la figure 4 représente un organigramme de recherche d'un page disponible ;
la figure 5 représente un organigramme de recherche de place disponible pour écrire une nouvelle donnée ;
la figure 6 représente un organigramme de détection d'une page pleine;
la figure 7 représente un organigramme de détection d'une mémoire pleine ;
la figure 8 représente un organigramme d'écriture d'une donnée ;
la figure 9 représente un organigramme de suppression d'une donnée
la figure 10 représente un organigramme de lecture d'une donnée ;
la figure 11 représente un organigramme de défragmentation de la mémoire ;
la figure 12 représente un organigramme de détection d'une défragmentation en cours ;
la figure 13 représente un organigramme de vérification de la cohérence du contenu de la mémoire ;

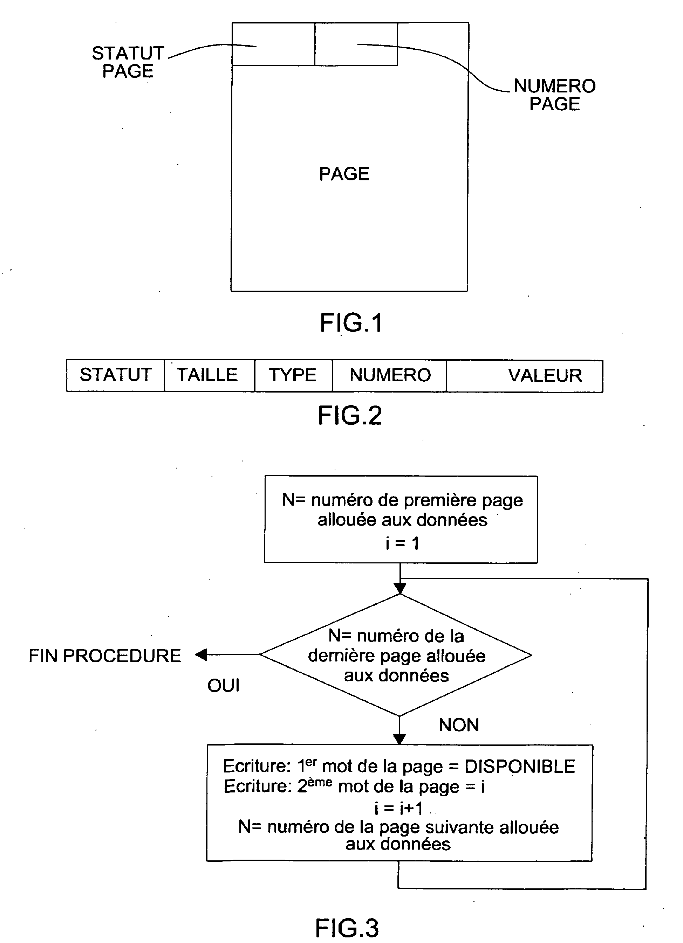

La figure 1 représente une page d'une mémoire de type FlashPROM dans laquelle l'invention est mise en oeuvre. Comme on l'a vu précédemment seule une partie de la mémoire peut être allouée au stockage des données. On considère néanmoins que plusieurs pages de la mémoire sont destinées à recevoir des données. Au début de chaque page prévue à cet effet on réserve une zone de taille fixe permettant de recevoir le statut et le numéro de la page. Le statut de chaque page peut prendre un nombre N de valeurs. Une particularité de la mémoire FlashPROM est la possibilité d'écrire une valeur unitairement une seule fois. Pour modifier ou effacer cette valeur il est nécessaire d'effacer la totalité de la page dans laquelle la valeur a été stockée. Pour pallier cette difficulté, les N valeurs se succédant séquentiellement et sont codées sur N - 1 bits. Par exemple, le statut de la page prend cinq valeurs suivantes : VIDE, RECOPIE, EFFACEMENT, DISPONIBLE, PLEINE. On verra par la suite la signification de ces valeurs. Les valeurs sont codées sur quatre bits. Avantageusement une transition entre deux valeurs successives se fait par modification d'un bit sans effacement. A l'initialisation de la mémoire tous les bits sont par exemple à 1 et la valeur « VIDE » s'exprime donc 1111. On peut modifier cette valeur qui devient RECOPIE en modifiant le dernier bit. RECOPIE s'exprime donc 1110. La valeur devient ensuite EFFACEMENT en changeant l'avant dernier bit pour s'exprimer 1100. De même DISPONIBLE s'exprime 1000 et PLEINE s'exprime 0000.

Avantageusement, le numéro de la page peut être structuré comme le statut afin de pouvoir être modifié.

La figure 2 représente la structure d'une donnée destinée à être stockée sur la page représentée sur la figure 1. Au début de la zone permettant de recevoir la donnée on réserve une zone de taille fixe permettant de recevoir le statut et la taille de la donnée. Le statut de la donnée est géré de la même façon que celui de la page. A titre d'exemple, le statut de la donnée prend par exemple quatre valeurs suivantes : LIBRE, EN COURS, OCCUPE et SUPPRIME. Ces quatre valeurs sont codées sur trois bits et se succèdent séquentiellement. A la suite de la taille, on peut prévoir une zone permettant de stocker le nom de la donnée. Dans l'exemple donné sur la figure 1 ce nom est formé de deux informations : type et numéro. Enfin à la suite du nom de la donnée une zone est prévue pour recevoir la valeur de la donnée.

La figure 3 représente un organigramme de préparation d'une page. Cet organigramme est utilisé lors du premier démarrage du dispositif contenant la mémoire. Le procédé modifie le statut de chaque page allouée au stockage de donnée pour y placer la valeur DISPONIBLE à l'exception de la dernière page qui sera utilisée pour la défragmentation de la mémoire. De plus le procédé numérote chronologiquement les différentes pages. Le statut et le numéro de la page forment les deux premiers mots de la page.

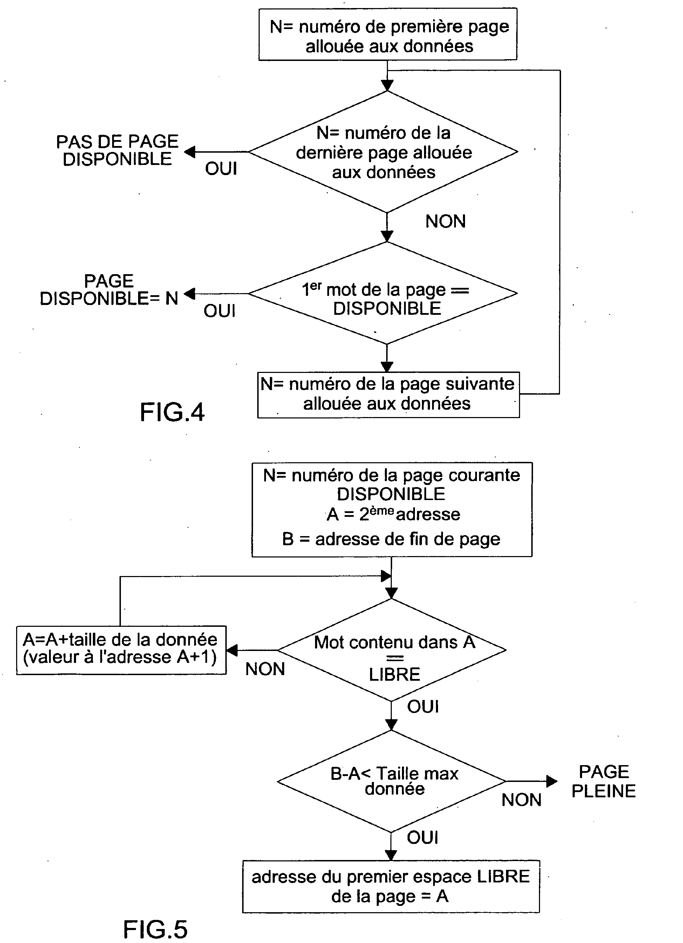

La figure 4 représente un organigramme de recherche d'un page disponible en recherchant chronologiquement dans les pages allouées au stockage des données la première page contenant le mot DISPONIBLE.

la figure 5 représente un organigramme de recherche de place disponible pour écrire une nouvelle donnée. Cette recherche se fait dans la page sélectionnée à l'aide de l'organigramme de la figure 4. Comme on l'a vu précédemment, les pages sont initialisées en plaçant tous les bits à 1. En prenant l'exemple décrit à l'aide de la figure 2 où le statut de chaque donnée peut prendre quatre valeurs et est donc codé sur trois bits. On prendra comme convention que la valeur LIBRE est codée 111. La valeur LIBRE représente donc le premier emplacement de la page pas encore utilisé après initialisation de la page. La recherche se fait en lisant le statut de chaque donnée de la page par saut de la taille de chaque donnée. Si la place disponible en fin de page « B - A », est inférieure à la taille « Taille max donnée » de la donnée à écrire, on déclare la page pleine et on modifie le statut de la page qui passe de DISPONIBLE à PLEINE par changement d'état d'un bit du statut de la page.

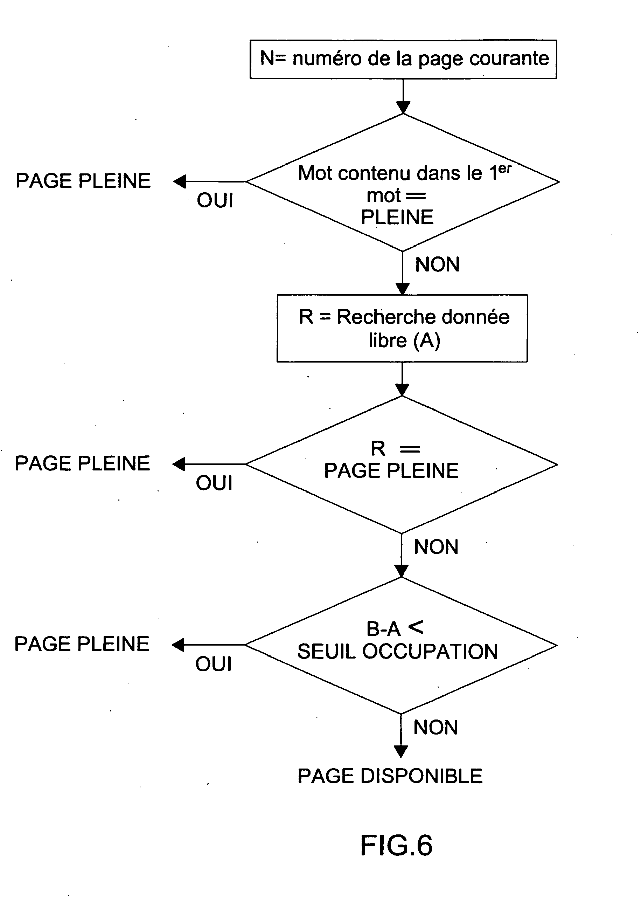

La figure 6 représente un organigramme de détection d'une page pleine. On peut définir un seuil d'occupation à ne pas dépasser pour chaque page dont le statut est DISPONIBLE. L'organigramme permet en complément de celui décrit sur la figure 5, de déclarer une page pleine.

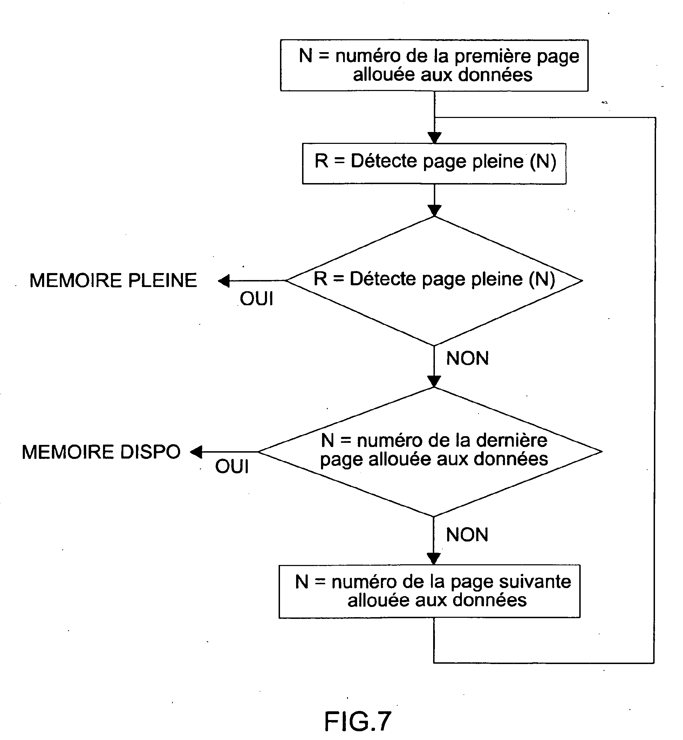

La figure 7 représente un organigramme de détection d'une mémoire pleine. La mémoire est dite pleine si plus aucune page ne comporte la valeur DISPONIBLE dans son statut.

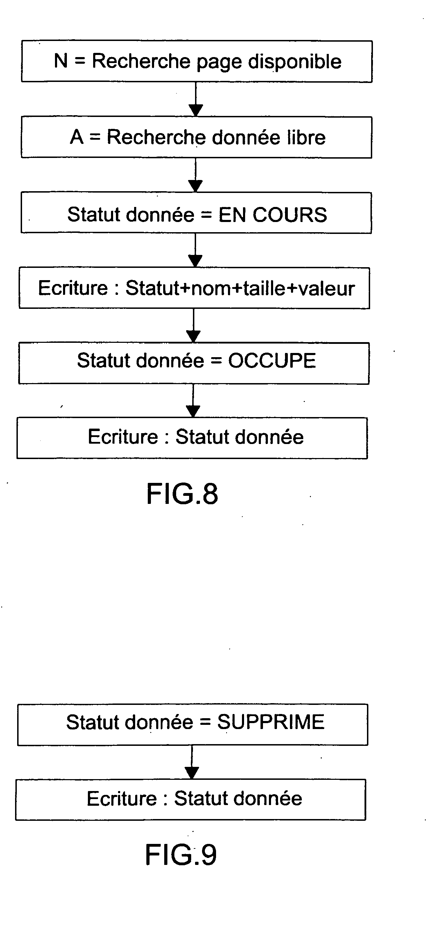

La figure 8 représente un organigramme d'écriture d'une donnée à l'emplacement retenu. A fin de sécuriser l'écriture de l'objet, on commence par modifier le statut de la donnée qui passe de LIBRE à EN COURS par modification d'un bit du mot contenant son statut. On écrit ensuite le nom , la taille et la valeur de la donnée. Puis on modifie le statut qui devient OCCUPE toujours par modification d'un bit du mot contenant le statut. Ainsi, si un problème intervient en cours d'écriture de la donnée, le statut, conservera la valeur EN COURS, signifiant que la donnée n'a pas terminé sa phase d'écriture et est donc non valide. A titre d'alternative, il est également possible d'utiliser l'information type de la donnée, illustrée sur la figure 2, pour s'assurer de l'écriture correcte de la donnée. Le type prend par exemple une valeur « INCONNU » en début d'écriture et est modifié par changement d'un bit en fin d'écriture si celle ci a été correctement faite.

La figure 9 représente un organigramme de suppression d'une donnée. Cet algorithme est utilisé en fonction de l'application si la valeur d'une donnée est modifiée. La mémoire FlashPROM ne permettant pas la mise à jour d'une valeur, à part le changement d'état d'un bit dans un sens seulement, si la valeur d'une donnée doit évoluer, on abandonne l'emplacement précédent de la donnée en modifiant son statut qui devient SUPPRIME par modification d'un bit du mot contenant le statut et on écrit la nouvelle valeur de la donnée à un autre emplacement disponible au moyen de l'organigramme de la figure 8.

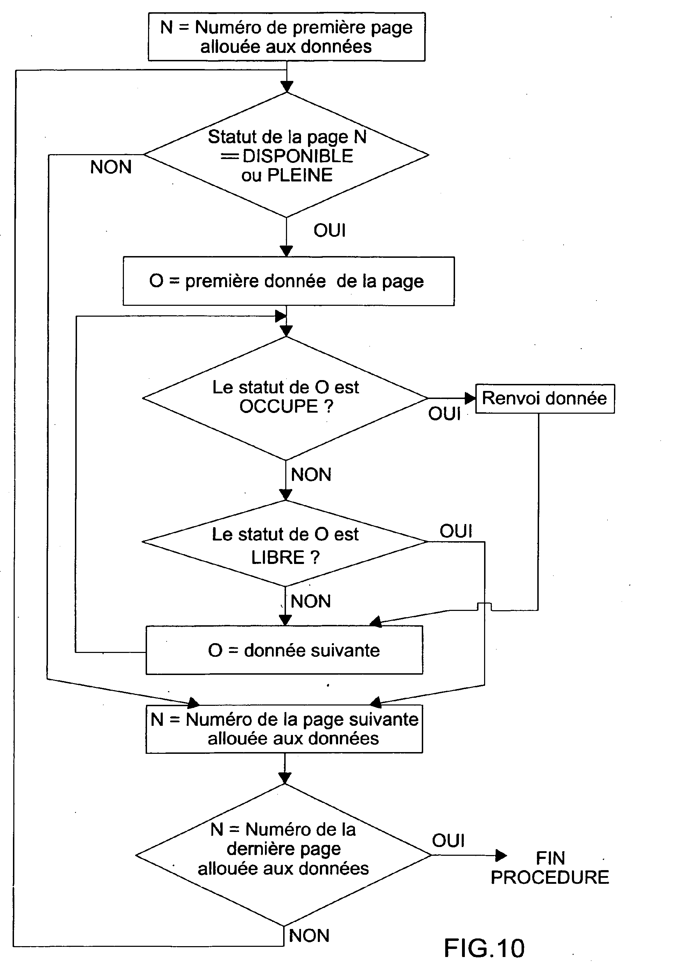

La figure 10 représente un organigramme de lecture d'une donnée valide. Les données valides sont celles dont le statut est occupé. Cet organigramme renvoi l'ensemble des données valides présentes dans la mémoire en balayant l'ensemble des pages contenant des données, pages dont le statut est DISPONIBLE ou PLEINE.

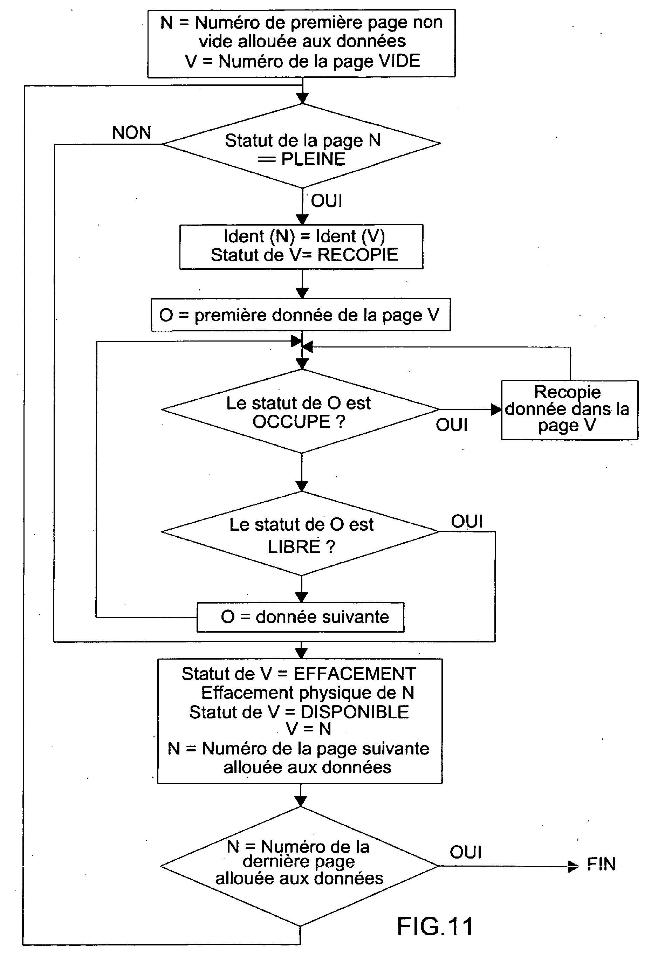

La figure 11 représente un organigramme de défragmentation de la mémoire. En effet, comme on l'a vu à l'aide de la figure 9, une donnée périmée continue d'occuper une zone de la mémoire. L'organigramme de la figure 11 permet de regrouper les données valides en éliminant les données périmées, celle dont le statut est SUPPRIME. Cet organigramme utilise la dernière page laissée libre et dont le statut est VIDE pour recopier d'une page dont le statut est PLEINE les données valides dont le statut est OCCUPE puis on efface la totalité de la page dont le statut est PLEINE qui devient une nouvelle page réservée à la défragmentation. Plus précisément, on modifie le statut VIDE qui devient RECOPIE. On modifie le numéro de la page sélectionné dont le statut est PLEINE par le numéro de la page dont le statut est RECOPIE. On recopie de la page dont le statut est PLEINE, les données dont le statut est OCCUPE vers la page dont le statut est RECOPIE. On modifie le statut RECOPIE en EFFACEMENT. On efface la totalité de la page dont le statut est PLEINE. Enfin on modifie le statut EFFACEMENT en DISPONIBLE.

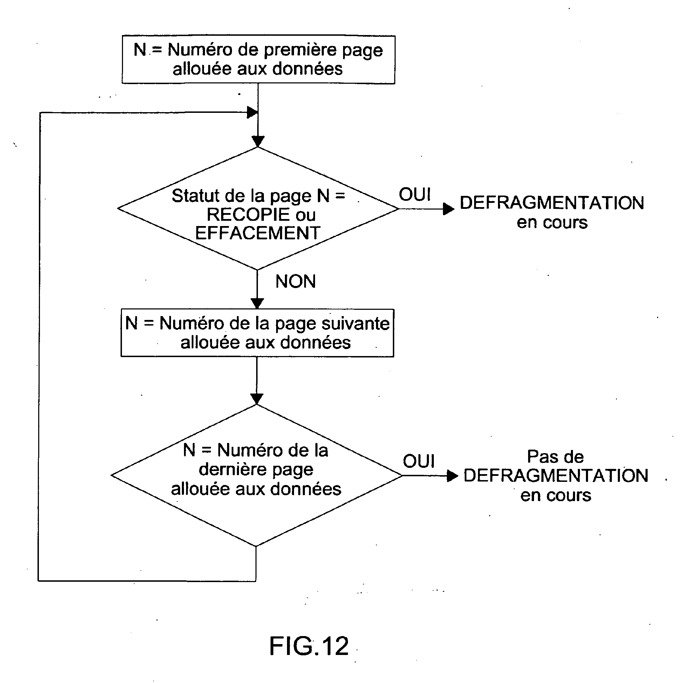

La figure 12 représente un organigramme de détection d'une défragmentation en cours. Cet organigramme est utilisé lors de la remise en route d'un système fonctionnant avec le procédé de l'invention. Cet organigramme permet de savoir si une défragmentation a été interrompue lors d'un arrêt du système. Une défragmentation est détectée si le statut d'une page est RECOPIE ou EFFACEMENT.

Il est possible d'éviter les défragmentations en cours d'opération et par exemple imposer une défragmentation en début d'opération en définissant un seuil d'occupation d'une page au-delà duquel le statut de d'une page passe de DISPONIBLE à PLEINE. Le seuil d'occupation est défini de telle sorte à permettre le stockage de toutes les données écrites entre deux allumages du système.

Pour éviter le cas où la mémoire est pleine et la défragmentation impossible par absence de donnée périmée, il est nécessaire de prévoir un nombre suffisant de pages mémoire pour obtenir quelques données périmées avant l'occupation totale de la mémoire.

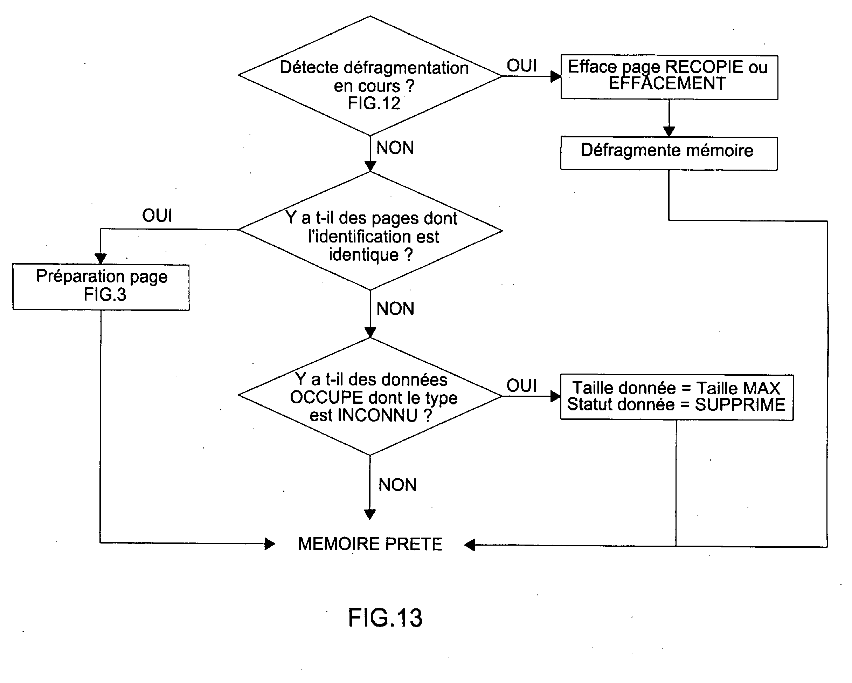

La figure 13 représente un organigramme de vérification de la cohérence du contenu de la mémoire. A chaque démarrage du système, le procédé vérifie la cohérence de la mémoire en supprimant toutes les données dont le type est INCONNU et en fixant leur taille, si celle-ci n'est pas renseignée, à la taille maximale des données. Cette suppression est réalisée en modifiant le statut de la donnée qui devient SUPPRIME. Le procédé ordonne une défragmentation si la mémoire est pleine ou si celle ci était en cours lors de la dernière extinction du système. Le procédé efface également le contenu d'une page dont le numéro serait identique à celui d'une autre. Cela serait le cas quand une extinction du système intervient lors de la préparation d'une page.

## Revendications

1. Procédé de gestion de données destinées à être écrites et lues dans une mémoire de type FLASHPROM organisée en pages et stockant plusieurs données par page, le procédé consistant:
• pour chaque page, à réserver une zone destinée à recevoir le statut et le numéro de la page,
• pour chaque donnée, à réserver une zone pour le statut et la taille de la donnée, et à réserver au moins une page permettant la défragmentation de la mémoire.

2. Procédé selon la revendication 1, **caractérisé en ce que** lors d'une défragmentation, on recopie les données valides (OCCUPE) d'une page pleine dans la page réservée à la défragmentation puis on efface la totalité de la page pleine qui devient une nouvelle page réservée à la défragmentation.

3. Procédé selon l'une des revendications précédentes, **caractérisé en ce que** le statut de chaque page ou de chaque donnée peut prendre un nombre N de valeurs, **en ce que** les valeurs se succèdent séquentiellement et sont codées sur N - 1 bits.

4. Procédé selon la revendication 3, **caractérisé en ce qu'**une transition entre deux valeurs successives se fait par modification d'un bit sans effacement.

## Claims

1. Method for managing data intended to be written to and read from a memory of FLASHPROM type organized into pages and storing several data per page, the method consisting:
• for each page, in reserving an area intended to receive the status and the number of the page,
• for each data item, in reserving an area for the status and the size of the data item, and
in reserving at least one page allowing the defragmentation of the memory.

2. Method according to Claim 1, **characterized in that** during a defragmentation, the valid data (OCCUPIED) of a full page are copied over into the page reserved for defragmentation, then the whole of the full page is erased and becomes a new page reserved for defragmentation.

3. Method according to one of the preceding claims, **characterized in that** the status of each page or of each data item can take a number N of values, **in that** the values follow one another sequentially and are coded on N - 1 bits.

4. Method according to Claim 3, **characterized in that** a transition between two successive values is made by modifying a bit without erasure.

## Patentansprüche

1. Verfahren zur Verwaltung von Daten, die dazu bestimmt sind, in einen Speicher vom Typ FLASHPROM eingegeben und aus ihm ausgelesen zu werden, der seitenweise strukturiert ist und mehrere Daten pro Seite speichert, wobei das Verfahren darin besteht:
• für jede Seite eine Zone zu reservieren, die dazu bestimmt ist, den Status und die Nummer der Seite zu empfangen,
• für jeden Datenwert eine Zone für den Status und die Größe des Datenwerts zu reservieren, und
mindestens eine Seite zu reservieren, die die Defragmentierung des Speichers erlaubt.

2. Verfahren nach Anspruch 1, **dadurch gekennzeichnet, dass** bei einer Defragmentierung die gültigen Daten (BESETZT) einer vollen Seite in die für die Defragmentierung reservierte Seite kopiert, dann die Gesamtheit der vollen Seite gelöscht wird, die zu einer neuen für die Defragmentierung reservierten Seite wird.

3. Verfahren nach einem der vorhergehenden Ansprüche, **dadurch gekennzeichnet, dass** der Status jeder Seite oder jedes Datenwerts eine Anzahl N von Werten annehmen kann, dass die Werte sequentiell aufeinander folgen und mit N - 1 Bits codiert sind.

4. Verfahren nach Anspruch 3, **dadurch gekennzeichnet, dass** ein Übergang zwischen zwei aufeinanderfolgenden Werten durch Veränderung eines Bits ohne Löschen erfolgt.
